# EUROPEAN PATENT SPECIFICATION

(11) **EP 0 296 834 B1**
(45) Date of publication and mention of the grant of the patent: **15.05.1996**
(21) Application number: 88305701.0
(22) Date of filing: 22.06.1988
(51) Int. Cl.: G01N 24/08

(54) **Magnetic resonance imaging methods and apparatus**
Verfahren und Apparat zur Bilderzeugung mittels magnetischer Resonanz
Procédé et appareil pour l'imagerie par résonance magnétique

(30) Priority: 24.06.1987 US 66039
(43) Date of publication of application: 28.12.1988
(73) Proprietor: PICKER INTERNATIONAL, INC., Highland Heights Ohio 44143 (US)
(72) Inventor: Denison, Kenneth S., Shaker Heights Ohio 44122 (US); Holland G. Neil, Chagrin Falls Ohio 44022 (US); Demeester, Gordon D., Wickliffe Ohio 44092 (US)
(74) Representative: McGowan, Nigel George

(56) References cited:
- EP-A- 0 107 294
- EP-A- 0 112 582
- WO-A-85/05693
- WO-A-87/00924
- US-A- 4 737 713
- Margosian, Schmitt : "Faster MR Imaging Methods"; Proc. SPIE 593 (1985), p. 6-13

## Description

This invention relates to magnetic resonance imaging methods and apparatus.

More especially, the invention relates to medical diagnostic magnetic resonance imaging methods and apparatus and finds particular application in conjunction with T2 weighted magnetic resonance imaging and will be described with particular reference thereto. It is to be appreciated, however, that the present invention may also be applicable to other image enhancement, modification, and improvement techniques.

Heretofore, medical diagnostic magnetic resonance imaging has included the sequential pulsing of radio frequency signals and magnetic field gradients across a region to be imaged. In two dimensional imaging, a patient is disposed within a region of interest in a substantially uniform main magnetic field. A slice select gradient is applied across the field to select a slice or other region of the patient to be imaged. A phase encode gradient is applied along one of the axes of the selected slice to encode the material with a selected phase angle along the phase encode axis. In subsequent repetitions of the pulse sequence, the phase encode gradient is stepped in regular increments between plus and minus Gmax, the maximum phase encode gradient.

A magnetic resonance inversion and/or other manipulation pulse is applied to cause a magnetic resonance echo. Additional inversion and/or other magnetization manipulation pulses are applied to create additional echoes following the same resonance excitation. Each repetition of the pulse sequence produces one set of sampled data points, generally termed a view or step, for each monitored echo. The set of views corresponding to each echo is separately Fourier transformed into an image representation. Alternately, image noise can be reduced and improved by time sampling and summing data or image echoes in each sequence.

Each view is phase encoded with a corresponding one of the phase encode gradient increments along one axis and frequency encoded along another. The central or zero phase encoded views and the low frequency components within each view contribute primarily to the contrast of the resultant multiple view image. The views phase encoded near the plus and minus Gmax and the high frequency components of each view contribute primarily to the fine detail or resolution.

The image from the first or earliest echo has the best fine detail and spatial resolution. The later echo images become noisier and the resolution degrades. However, the later images have other properties, such as a better resolved T2 contrast, which make them diagnostically more advantageous than the early images. Thus, for good detailed resolution, an early echo image is selected; whereas, for good T2 contrast a late echo image is selected.

The reduced signal-to-noise and anatomical detail of the late echo or long TE images compromise their diagnostic value. To improve the late echo diagnostic value, it has been proposed that transformed data corresponding to a complete early echo image and a complete late echo image be combined and subsequently further processed to produce one synthetic image with selected characteristics of each. More specifically, measurement dependent filtering is utilized to remove the low spatial frequency contribution from the compete late echo image and the high spatial frequency contribution from the complete early echo image. A spatially-variant control function determines the relative amounts of high and low frequency information that are combined into the single synthetic image. However, such combining and manipulating of the complete transformed image data is computationally intensive and requires significant computer time.

EP-A-0112582 discloses a superposed image display device having display means for displaying a plurality of image signals. The device further comprises means for memorizing a plurality of image signals obtained by photographing the same part by a plurality of image diagnostic apparatuses, and superposing means for performing predetermined image processings respectively to said image signals read out from said memory means and for adding the processed image signals, the added image signal being supplied to said display means.

"Faster MR Imaging Methods"; P. Margosian, F. Schmitt: Proc. SPIE, 593 (1985), pages 6-13 discloses a fast imaging method using multiple echoes for faster data acquisition. The basic idea is to take a multiple echo scan while each echo is differently phase encoded and to synthesise from this data a raw data set which is reconstructed by an FFT or backprojection algorithm. The best strategy is to take the low frequency measurements from the lowest numbered echoes and the higher frequency measurement from the later echoes.

It is an object of the present invention to provide a magnetic resonance imaging method and apparatus wherein this problem is overcome.

According to a first aspect of the present invention there is provided a method of magnetic resonance imaging comprising the steps of: exciting magnetic resonance of dipoles in an image region; after each excitation of magnetic resonance, causing a plurality of magnetic resonance echoes, early echoes close in time to the excitation having better resolution of details of structure in the image region and poorer T2 contrast and late echoes further in time from the excitation having poorer structural detail resolution and better T2 contrast; and collecting magnetic resonance signals during the early and late echoes to collect early echo data and late echo data; characterised by the steps of: separating high spatial frequency components from the early echo data and low spatial frequency components from the late echo data; combining the separated high and low frequency components to produce a synthesized data set; and Fourier transforming the synthesized data set to produce a synthetic image which has detail resolution like an early echo image and T2 contrast like a late echo image.

According to a second aspect of the present invention there is provided a magnetic resonance imaging apparatus comprising:
means for exciting magnetic resonance of dipoles in an image region; an echo means for selectively causing at least two magnetic resonance echoes; a phase encoding means for selectively adjusting a phase encoding in the excited magnetic resonance from excitation to excitation; and a collecting means for receiving magnetic resonance signals generated by the dipoles during the echoes and digitizing the received signals to generate echo data corresponding to at least a first and a second of the said at least two echoes; a first echo data memory means for storing echo data corresponding to the first echo; a second echo data memory means for storing echo data corresponding to the second echo; characterised by: a first filter means for separating the components of high spatial frequencies of the echo data in the first echo data memory means; a second filter means for separating the components of low spatial frequencies of the echo data in the second echo data memory means; a combining means for combining and synthesizing said separated components of high and low spatial frequencies into a synthesized data set and for storing said synthesized data set into a synthesized data memory means and a transforming means for transforming said stored synthesized data set into an image representation.

One advantage of the present invention is that low noise, high contrast, high anatomical detail synthetic images are produced. The best features of short and long echo time images are achieved in a single image.

Another advantage of the present invention is that the computational load is reduced.

Another advantage of the present invention resides in the elimination of image phase errors.

Yet another advantage of the present invention resides in the elimination of misalignment between short and long echo time images.

One magnetic resonance imaging method and apparatus in accordance with the present invention will now be described, by way of example, with reference to the accompanying drawing, in which:
Figure 1 is a digrammatic illustration of the magnetic resonance imaging apparatus; and
Figure 2 is a graphic representation to assist in conceptualizing a synthetic array or set of data for transformation into an image representation.

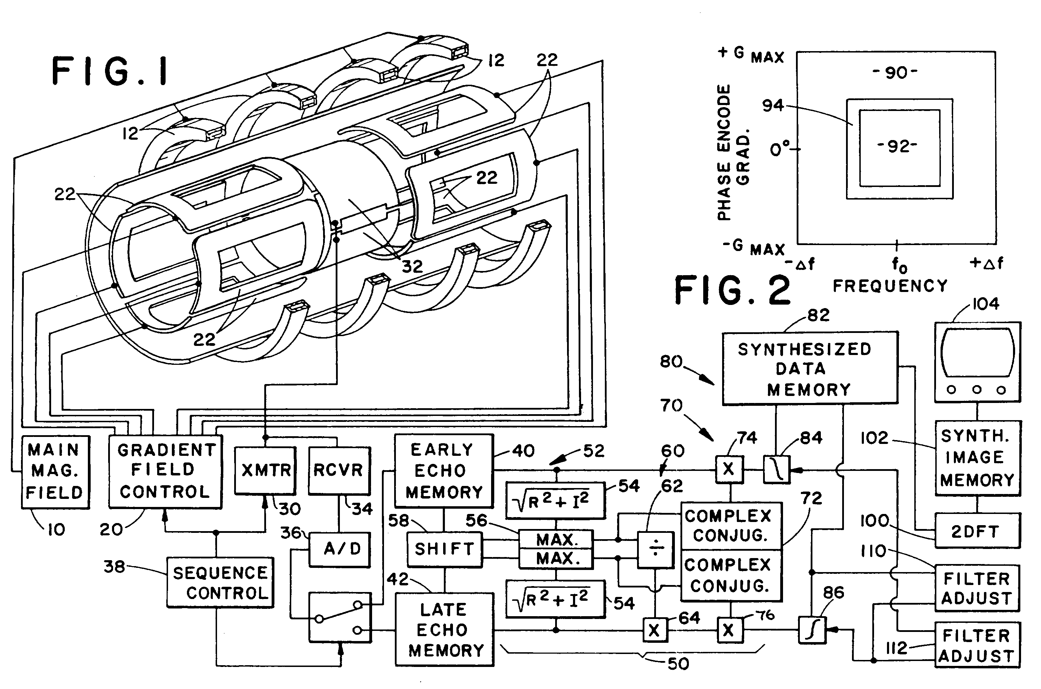

Referring to FIGURE 1, magnetic resonance is excited in an image region of the magnetic resonance imaging apparatus. A main magnetic field means, including a main magnetic field controller 10 and a plurality of electromagnets 12, generate a substantially uniform, main magnetic field through the image region. A gradient field control means 20 selectively controls the application of gradient fields across the main magnetic field by gradient field coils 22. By selectively applying current pulses to appropriate ones of the gradient field coils, slice select, phase encode, and read gradients are selectively applied along mutually orthogonal axes to define an image slice or region. A transmitter 30 selectively supplies radio frequency pulses to RF coils 32 to excite dipoles in the image region to magnetic resonance and to manipulate or orient the magnetization of the resonating dipoles. Magnetic resonance signals generated by the resonating dipoles are received by the RF coils 32. A radio frequency receiver 34 demodulates the received radio frequency signals to a band width of fₒ ± Δ f, where fₒ is preferably zero. The signals are digitized by an analog-to-digital converter 36. A timing and control means 38 controls the timing and application of the gradient and radio frequency pulses to perform imaging sequences as are well known in the art.

Each imaging sequence commonly includes causing the gradient field control means 20 to apply a slice select gradient along the main magnetic field. The transmitter 30 generates an RF magnetic resonance excitation pulse and the gradient field control causes slice select and phase encode gradient pulses. A magnetic resonance inversion pulse from transmitter 30 causes a first or early echo concurrently with application of one or more read gradient pulses by the gradient control means. During the first echo, a magnetic resonance signal is received by the receiver 34 and digitized by the analog-to-digital converter 36 to form a first view or line of digital data corresponding to the first echo. Another magnetic resonance inversion pulse along with at least one additional read gradient pulse is applied to cause a second echo. The magnetic resonance signal during the second echo is received by the receiver 34 and digitized by the analog-to-digital converter 36 to form one view or a line of second echo digital data. The application of inversion and read gradient pulses is repeated to form third, fourth, and subsequent later echoes each of which is received and digitized. The views corresponding to each echo are stored in corresponding view memories, such as a first or early echo view memory 40 and a late echo view memory 42.

Each view is commonly identified by the value of the phase encoding gradient with which the resonance data was encoded. Commonly, a preselected number of views, e.g. 256 views, corresponding to phase encode gradients that vary in like steps from -Gmax to +Gmax, are collected separately for each echo. Each view or data line is frequency encoded by the read gradient pulse and includes a plurality of frequency components. The low frequency components of each view, i.e. the data near the zero frequency center of the line or view, contributes to contrast of the final image. The high frequency components near the ends of each line or view contribute to the detail or resolution. Analogously, the views which are phase encoded with a phase encoding gradient close to zero contribute low frequency components to the resultant image, hence, more contrast and less detail or resolution. The larger phase encoded views, i.e. those towards plus or minus Gmax, contribute the highest frequency components to the resultant image, hence, contribute more to the resolution and less to the contrast.

The data in each echo memory may be conceptualized as a rectangular array or matrix of data points each having a real and an imaginary part. The matrix has a frequency axis which may be conceptualized as the horizontal axis and a phase encode axis conceptualized as vertical. The data points along a horizontal row of memory elements would be the digitized resonance data of a single view. The data points along a vertical column would be the corresponding frequency data points taken with each of the different phase encode gradient steps or values.

Commonly, the data in the two echo data memories will not be in exact correspondence. Rather, the central frequency may be shifted or off center in one of the matrices, the phase angle may have an offset or different offsets, and the magnitude of the late echo data is conventionally lower than the magnitude of the early echo data. Early and late echo correlation means 50 are provided to correlate the data in the early and late echo data memory means.

A centering means 52 centers the data in each of the echo memories. Preferably, the centering means centers each ray of views along both axes. That is, the centering means searches for the data value corresponding to the center or minimum frequency of the view with the zero or minimum phase encoding. This central frequency and phase data value corresponds to the strongest resonance signal, hence can be identified by its maximum amplitude. The data in each echo memory is shifted to move the central data value to a preselected address, preferably the center. Any empty data points at the edges may be filled with a zero and any extra data points at the other edges may be discarded.

More specifically, a magnitude means 54 measures the magnitude of the complex data values stored at each data point of the first and second echo data memory means. Preferably, the magnitude is measured by taking the square root of the sum of the square of the real part and the square of the imaginary part. A maximum searching means 56 locates the maximum magnitude data value stored in each memory means. A data shifting means 58 shifts the data in each memory means such that the maximum magnitude data value is in the center of the matrix and fills any empty data points with data values of zero.

Normally, the later echoes are weaker than the earlier echoes which causes a correspondingly lower magnitude in the later echo data points. A normalizing means 60 normalizes the early and late echo data. In the preferred embodiment, the normalizing means includes a ratio means 62 for determining the ratio of maximum early echo magnitude to the maximum later echo magnitude. A multiplier 64 multiplies the smaller, late echo data values by the ratio. This enlarges the late echo data to correspond to the early echo data.

After the data is normalized, a zero order phase correction means 70 rotates the data values of each matrix such that the data values at the center data point have the same vector angle, preferably by zeroing the complex part of both. A complex conjugate means 72 determines the complex conjugate of the maximum magnitude data value that was shifted to the center data point. A first multiplying means 74 multiplies each data value of the early echo memory means 40 by the complex conjugate of the largest magnitude data value from the central early echo data point. Analogously, a second multiplying means 76 multiplies each data value of the later echo memory 42 by the complex conjugate of maximum magnitude data value from the late echo memory central data point. This rotates the phase of each data value in each of the early and late echo matrices by consistent amounts which bring the phase of the central data point of both memory means into correspondence.

Optionally, other data corrections or adjustments may be made to the data. For example, redundant views may be collected and averaged, each view may be adjusted, aligned, or correlated with the other views in the same echo data memory means, or the like.

A combining means 80 combines a portion of the early echo data with a complementary portion of the late echo data to produce a synthesized data set which is stored in a synthetic data memory 82. Preferably, the combining means includes a digital high pass filter 84 for separating the high frequency components of the early echo data and a digital low pass filter 86 for separating the complementary low frequency data of the late echo data set. Preferably, the filters are roll-off filters such that when combined the data adjacent the high-low frequency interface is averaged or smoothed.

As illustrated in FIGURE 2, the high pass filter 84 passes the high frequency data values from the data points in a peripheral region 90 of the early echo memory means 40. That is, it passes the data attributable to the large or higher phase encode values and the high frequency portions of the data attributable to the low phase encoded data. The low pass filter 86 passes the low frequency data values which are found in a central region of the more centrally or lower phase encoded data lines. The use of roll-off filters creates a region 94 in which the high frequency data of the early echo and the low frequency data of the late echo are averaged. By selecting complementary filters, the synthesized data set includes a single, complex data value for each data point. No data points are skipped and none are provided with two data values. The data points in the peripheral region 90 come from the corresponding data points in the early echo memory means. The data points in the central region 92 come from the corresponding data points of the late echo memory means. The data points in the interface region are the sum of complementary fractional portions of the corresponding data points of the early and late echo memory means. For example, the complementary fractional portions may be one quarter of one and three quarters of the other or one half of each, or one eighth and seven eighths, etc.

A two dimensional Fourier transform means 100 transforms the synthesized data in the synthetic data memory 82 into a image repesentation for storage in a synthetic image memory 102. A man readable display means 104 may be provided for displaying from the synthetic image memory.

For greater versatility, the interface between the high and low frequency regions is adjustable. A filter adjusting means 110 adjusts the complementary slope of filters 84, 86. At one extreme the complementary filters may be opposite step functions such that region 94 is eliminated and each data point of the synthesized data matrix is attributed solely to one of the early and late echo data sets. The filter adjusting means may increase the amount of roll-off which increases the width of the averaged region 84.

A second adjusting means 110 adjusts the relative contribution of the early and late echo data. Conceptually, this may be visualized as adjusting the relative sizes of regions 90 and 92. When the late echo is relatively noise-free, the size of region 92 may be increased relative to the size of region 90. This increases the contribution from the late echo data and emphasizes the improved contrast aspect of the invention. When the late echo is relatively noisy, it may be advantageous to reduce its contribution by reducing the size of region 92 and increasing the size of region 90. This improves the resolution of the resultant image.

## Claims

1. A method of magnetic resonance imaging comprising the steps of: exciting magnetic resonance of dipoles in an image region; after each excitation of magnetic resonance, causing a plurality of magnetic resonance echoes, early echoes close in time to the excitation having better resolution of details of structure in the image region and poorer T2 contrast and late echoes further in time from the excitation having poorer structural detail resolution and better T2 contrast; and collecting magnetic resonance signals during the early and late echoes to collect early echo data and late echo data; characterised by the steps of: separating high spatial frequency components from the early echo data and low spatial frequency components from the late echo data; combining the separated high and low frequency components to produce a synthesized data set; and Fourier transforming the synthesized data set to produce a synthetic image which has detail resolution like an early echo image and T2 contrast like a late echo image.

2. A method according to Claim 1 further including: before the combining step, the steps of storing the collected early and late echo data and wherein the combining step includes combining the stored early and late echo data.

3. A method according to Claim 2 further including the step of normalizing the magnitude of at least one of the stored early and late echo data to render the magnitude of the early and late echo data compatible.

4. A method according to Claims 2 or 3 further including the step of adjusting the phase of at least one of the stored early and late echo data to bring the phase of the stored early and late echo data into conformity.

5. A method according to Claims 2, 3 or 4 further including the step of centring the stored early and late echo data to bring the early and late echo data into alignment.

6. A method according to Claim 5, wherein the centring step includes determining the data value with the largest magnitude in each of the early and late echo data and shifting such determined largest magnitude data values to preselected, corresponding points.

7. A method according to Claim 6 further including the step of adjusting the phase of the early echo data such that the largest magnitude echo data value has a zero complex part and adjusting the phase of the late echo data such that the largest magnitude late echo data value has a zero complex part.

8. A magnetic resonance imaging apparatus comprising: means (30,32) for exciting magnetic resonance of dipoles in an image region; an echo means (30,32) for selectively causing at least two magnetic resonance echoes; a phase encoding means (20,22) for selectively adjusting a phase encoding in the excited magnetic resonance from excitation to excitation; and a collecting means (34,36) for receiving magnetic resonance signals generated by the dipoles during the echoes and digitizing the received signals to generate echo data corresponding to at least a first and a second of the said at least two echoes; a first echo data memory means (40) for storing echo data corresponding to the first echo; a second echo data memory means (42) for storing echo data corresponding to the second echo; characterised by: a first filter means (84) for separating the components of high spatial frequencies of the echo data in the first echo data memory means (40); a second filter means (86) for separating the components of low spatial frequencies of the echo data in the second echo data memory means (42); a combining means (80) for combining and synthesizing said separated components of high and low spatial frequencies into a synthesized data set and for storing said synthesized data set into a synthesized data memory means (82) and a transforming means (100) for transforming said stored synthesized data set into an image representation.

9. An apparatus according to Claim 8 further including a centring means (52) operatively connected with the first and second echo data memory means (40,42) to bring the echo data in the first and second echo data memory means (40,42) into registration.

10. An apparatus according to Claims 8 or 9 further including a normalizing means (60) for adjusting a magnitude of the echo data stored in at least one of the first and second echo data memory means (40,42) to bring the magnitude of the echo data stored in the first and second memory means (40,42) into correspondence.

11. An apparatus according to Claims 8, 9 or 10 further including a phase correction means (70) for adjusting the relative phase of the echo data stored in the first and second echo data memory means (40,42) into correspondence.

12. An apparatus according to Claim 8, wherein each echo data includes a plurality of data values each having a real component and an imaginary component and a further including means (54) for calculating a magnitude of each echo data value.

13. An apparatus according to Claim 12, wherein said means (54) for calculating forms part of a centring means (52) for finding the data value in each of the first and second echo data memory means (40,42) which has the largest magnitude and for shifting the echo data in at least one of the first and second echo data memory means (40,42) to bring the largest magnitude data values to the same coordinates in both the first and second echo data memory means (40,42).

14. An apparatus according to Claims 12 or 13 further including a normalizing means (60) for multiplying the magnitude of each data value in one of the first and second echo data memory means (40,42) by the ratio of the largest magnitude data values in the first and second echo data memory means (40,42).

15. An apparatus according to Claims 12, 13 or 14 further including means for multiplying (74) each data value in the first echo data memory means (40) by the complex conjugate of the largest magnitude data value in the first echo memory means (40) and means for multiplying (76) each data value in the second echo data memory means (42) by the complex conjugate of the largest magnitude data value in the second echo data memory means (42).

## Patentansprüche

1. Verfahren zur Bilderzeugung mittels magnetischer Resonanz, aufweisend die Schritte: Anregen der magnetischen Resonanz von Dipolen in einer Abbildungsregion; Hervorrufen mehrerer Magnetresonanz-Echos, frühe Echos zeitlich nahe an der Anregung, die eine bessere Auflösung im Detail der Struktur in der Abbildungsregion und einen schlechteren T2 Kontrast aufweisen, und spätere Echos zeitlich weiter von der Anregung entfernt, die eine schlechtere strukturelle Detailauflösung und einen besseren T2 Kontrast aufweisen, nach jeder Magnetresonanzanregung; und Erfassen von Magnetresonanzsignalen während der frühen und späten Echos zur Ansammlung von frühen Echodaten und späten Echodaten; gekennzeichnet durch die Schritte: Abtrennen von hohen Ortsfrequenzkomponenten aus den frühen Echodaten und niedrigen Ortsfrequenzkomponenten aus den späten Echodaten; Kombinieren der abgetrennten hohen und niedrigen Frequenzkomponenten zur Erzeugung eines Satzes synthetisierter Daten; und Fouriertransformieren des synthetisierten Datesatzes zur Erzeugung eines synthetischen Bildes, welches eine Detailauflösung wie ein frühes Echobild und einen T2 Kontrast wie eine spätes Echobild aufweist.

2. Verfahren nach Anspruch 1, ferner umfassend: vor dem Kombinationsschritt die Schritte der Speicherung der angesammelten frühen und späten Echodaten, und in welchem der Kominationsschritt das Kombinieren der gespeicherten frühen und späten Echodaten umfaßt.

3. Verfahren nach Anspruch 2, ferner umfassend den Schritt der Normierung des Betrags zumindest einer, der gespeicherten frühen und späten Echodaten, um den Betrag der frühen und späten Echodaten kompatibel zu gestalten.

4. Verfahren nach Anspruch 2 oder 3, ferner umfassend den Schritt der Einstellung der Phase zumindest einer, der gespeicherten frühen und späten Echodaten, um die Phase der gespeicherten frühen und späten Echodaten auf Konformität zu bringen.

5. Verfahren nach Anspruch 2, 3 oder 4, ferner umfassend den Schritt der Zentrierung der gespeicherten frühen und späten Echodaten, um die frühen und späten Echodaten in Ausrichtung zu bringen.

6. Verfahren nach Anspruch 5, in welchem der Zentrierungsschritt beinhaltet, den Datenwert mit dem größten Betrag in jeder der frühen und späten Echodaten zu ermitteln und die derart bestimmten größten Betragsdatenwerte auf vorselektierte, entsprechende Punkte zu verschieben.

7. Verfahren nach Anspruch 6, ferner umfassend den Schritt der Einstellung der Phase der frühen Echodaten derart, daß der Echodatenwert mit dem größten Betrag einen komplexen Anteil von Null aufweist, und der der Einstellung der Phase der späten Echodaten derart, daß der späte Echodatenwert mit dem größten Betrag einen komplexen Anteil von Null aufweist.

8. Apparat zur Bilderzeugung mittels magnetischer Resonanz, aufweisend: eine Einrichtung (30, 32) zur Anregung magnetischer Resonanz von Dipolen in einer Abbildungsregion; eine Echoeinrichtung (30, 32) zur selektiven Hervorrufung zumindest zweier magnetischer Resonanzechos; eine Phasencodierungseinrichtung (20, 22) zur selektiven Einstellung einer Phasencodierung in der angeregten magnetischen Resonanz von Anregung zu Anregung; und eine Erfassungseinrichtung (34, 36) zum Empfangen von Magnetresonanzsignalen, die von den Dipolen während der Echos erzeugt werden, und zur Digitalisierung der empfangenen Signale zur Erzeugung von Echodaten entsprechend zumindest einem ersten und einem zweiten der zumindest zwei Echos; eine Speichereinrichtung (40) für erste Echodaten zur Speicherung der Echodaten entsprechend dem ersten Echo; eine Speichereinrichtung (42) für zweite Echodaten zum Speichern der Echodaten entsprechend dem zweiten Echo; gekennzeichnet durch: eine erste Filtereinrichtung (84) zum Abtrennen der Komponenten hoher Ortsfrequenzen der Echodaten in der Speichereinrichtung (40) für die ersten Echodaten; eine zweite Filtereinrichtung (86) zum Abtrennen der Komponenten niedriger Ortsfrequenzen der Echodaten in der Speichereinrichtung (42) für die zweiten Echodaten; eine Kombinationseinrichtung (80) zum Kombinieren und zur Synthetisierung der abgetrennten Komponenten hoher und niedriger Ortsfrequenzen zu einem Satz synthetisierter Daten und zum Speichern des synthetisierten Datensatzes in einer Speichereinrichtung (82) für synthetisierte Daten, und eine Transformationseinrichtung (100) zur Transformation des gespeicherten synthetisierten Datensatzes in eine Bilddarstellung.

9. Apparat nach Anspruch 8, ferner umfassend eine Zentriereinrichtung (52), die betriebswirksam mit der ersten und zweiten Echodatenspeichereinrichtung (40, 42) verbunden ist, um die Echodaten in der ersten und zweiten Echodatenspeichereinrichtung (40, 42) auf Passung zu bringen.

10. Apparat nach Anspruch 8 oder 9, ferner umfassend eine Normiereinrichtung (60) zur Einstellung eines Betrags der Echodaten, die in zumindest einem der ersten und zweiten Echodatenspeichereinrichtungen (40, 42) gespeichert sind, um den Betrag der in der ersten und zweiten Speichereinrichtung (40, 42) gespeicherten Echodaten auf Übereinstimmung zu bringen.

11. Apparat nach Anspruch 8, 9 oder 10, ferner umfassend eine Phasenkorrektureinrichtung (70) zur Einstellung der relativen Phase der Echodaten, die in der ersten und zweiten Echodatenspeichereinrichtung (40, 42) gespeichert sind, auf Übereinstimmung.

12. Apparat nach Anspruch 8, in welchem die Echodaten jeweils mehrere Datenwerte jeweils mit einer realen Komponente und einer imaginären Komponente umfassen, und ferner aufweisend eine Einrichtung (54) zum Berechnen des Betrags jedes Echodatenwerts.

13. Apparat nach Anspruch 12, in welcher die Einrichtung (54) zum Berechnen Teil e.iner Zentriereinrichtung (52) bildet, die den Datenwert in jeder der ersten und zweiten Echodatenspeichereinrichtung (40, 42), der den größten Betrag aufweist, auffindet und die Echodaten in zumindest einer der ersten und zweiten Echodatenspeichereinrichtung (40, 42) so verschiebt, daß die Datenwerte größten Betrags in beiden, der ersten und zweiten Echodatenspeichereinheit (40, 42), auf dieselben Koordinaten gebracht werden.

14. Apparat nach Anspruch 12 oder 13, ferner umfassend eine Normiereinrichtung (60) zur Multiplizierung des Betrags jedes Datenwerts in einer der ersten und zweiten Echodatenspeichereinrichtung (40, 42) mit dem Verhältnis der Datenwerte größten Betrags in der ersten und zweiten Echodatenspeichereinrichtung (40, 42).

15. Apparat nach den Ansprüchen 12, 13 oder 14, ferner umfassend eine Einrichtung zum Multiplizieren (74) jedes Datenwerts in der ersten Echodatenspeichereinrichtung (40) mit dem Komplex-Konjugierten des Datenwerts größten Betrags in der ersten Echodatenspeichereinrichtung (40) und eine Einrichtung zum Multiplizieren (76) jedes Datenwerts in der zweiten Echodatenspeichereinrichtung (42) mit dem Komplex-Konjugierten des Datenwerts gröβen Betrags in der zweiten Echodatenspeichereinrichtung (42).

## Revendications

1. Procédé de formation d'image par résonance magnétique, comprenant les étapes suivantes : l'excitation à la résonance magnétique de dipôles dans une région de formation d'image, après chaque excitation de la résonance magnétique, le déclenchement de plusieurs échos de résonance magnétique, des échos précoces proches de l'excitation au cours du temps ayant une meilleures résolution des détails de la structure se trouvant dans la région de formation d'image et un plus mauvais contraste T2 alors que les échos tardifs, plus éloignés de l'excitation, ont une moins bonne résolution de détails de la structure et un meilleur contraste T2, et la collecte des signaux de résonance magnétique pendant les échos précoce et tardif pour la collecte des données d'écho précoce et des données d'écho tardif, caractérisé par les étapes suivantes : la séparation des composantes de fréquences spatiales élevées des données d'écho précoce et des composantes à faibles fréquences spatiales des données d'écho tardif, la combinaison des composantes séparées à hautes fréquences et à basses fréquences pour la création d'un ensemble de données synthétisées, et la transformation de Fourier de l'ensemble de données synthétisées pour la création d'une image synthétisée ayant une résolution de détails analogue à une image d'écho précoce et un contraste T2 analogue à celui d'une image d'écho tardif.

2. Procédé selon la revendication 1, comprenant en outre, avant l'étape de combinaison, des étapes de mémorisation des données collectées d'écho précoce et d'écho tardif, et l'étape de combinaison comprend la combinaison des données d'écho précoce et d'écho tardif qui sont mémorisées.

3. Procédé selon la revendication 2, comprenant en outre une étape de normalisation de l'amplitude au moins des données mémorisées d'écho précoce ou d'écho tardif afin que l'amplitude des données d'écho précoce et celle des données d'écho tardif soient compatibles.

4. Procédé selon la revendication 2 ou 3, comprenant en outre l'étape d'ajustement de la phase de données mémorisées d'écho précoce ou d'écho tardif au moins de manière que les phases des données mémorisées d'écho précoce et d'écho tardif se correspondent.

5. Procédé selon la revendication 2, 3 ou 4, comprenant en outre l'étape de centrage des données mémorisées d'écho précoce et d'écho tardif de manière que les données d'écho précoce et d'écho tardif soient alignées.

6. Procédé selon la revendication 5, dans lequel l'étape de centrage comprend la détermination de la valeur des données ayant la plus grande amplitude dans chaque ensemble de données d'écho précoce et d'écho tardif et le décalage des valeurs déterminées de données de plus grande amplitude en des points prédéterminés correspondants.

7. Procédé selon la revendication 6, comprenant en outre l'étape d'ajustement de la phase des données d'écho précoce de manière que la valeur des données d'écho de plus grande amplitude ait une partie complexe nulle, et l'ajustement de la phase des données d'écho tardif de manière que la valeur des données d'écho tardif de plus grande amplitude ait une partie complexe nulle.

8. Appareil de formation d'image par résonance magnétique, comprenant un dispositif (30, 32) d'excitation de la résonance magnétique de dipôles dans une région de formation d'image, un dispositif (30, 32) de création sélective d'au moins deux échos de résonance magnétique, un dispositif (20, 22) de codage de phase destiné à ajuster sélectivement un codage de phase dans la résonance magnétique excitée, d'une excitation à une autre, et un dispositif collecteur (34, 36) destiné à recevoir le signaux de résonance magnétique créés par les dipôles pendant les échos et à numériser les signaux reçus pour la création de données d'écho correspondant au moins à un premier et un second des deux échos au moins, un dispositif (40) de mémoire de données du premier écho destiné à mémoriser les données d'écho correspondant au premier écho, et un dispositif (42) de mémoire de données du second écho destiné à mémoriser les données d'écho correspondant au second écho, caractérisé par un premier dispositif de filtrage (84) destiné à séparer les composantes de fréquences spatiales élevées des données d'écho dans le dispositif (40) de mémoire de données de premier écho, un second dispositif de filtrage (86) destiné à séparer les composantes à faibles fréquences spatiales des données d'écho dans le dispositif (42) de mémoire des données du second écho, un dispositif (80) de combinaison et de synthèse des composantes séparées des fréquences spatiales élevées et faibles en un ensemble de données synthétisées et à mémoriser l'ensemble de données synthétisées dans un dispositif (82) de mémoire de données synthétisées, et un dispositif (100) de transformation de l'ensemble de données synthétisées mémorisées en une représentation d'image.

9. Appareil selon la revendication 8, comprenant en outre un dispositif de centrage (52) connecté pendant le fonctionnement aux dispositifs (40, 42) à mémoire de données du premier et du second écho de manière que les données d'écho dans les dispositifs (40, 42) de mémoire de données du premier écho et du second écho soient alignées.

10. Appareil selon la revendication 8 ou 9, comprenant en outre un dispositif de normalisation (60) destiné à ajuster l'amplitude des données d'écho mémorisées dans l'un au moins des dispositifs (40, 42) de mémoire de données du premier écho et du second écho afin que l'amplitude des données d'écho conservées dans le premier et le second dispositif de mémoire (40, 42) se correspondent.

11. Appareil selon la revendication 8, 9 ou 10, comprenant en outre un dispositif (70) de correction de phase destiné à ajuster la phase relative des données d'écho mémorisées dans les dispositifs (40, 42) de mémoire de données de premier écho et de second écho de manière correspondante.

12. Appareil selon la revendication 8, dans lequel les données d'écho comprennent plusieurs valeurs de données ayant chacune une composante réelle et une composante imaginaire, et un dispositif (54) de calcul de l'amplitude de chaque valeur de données d'écho est incorporé.

13. Appareil selon la revendication 12, dans lequel le dispositif (54) de calcul fait partie d'un dispositif de centrage (52) destiné à déterminer la valeur des données dans chacun des dispositifs (40, 42) de mémoire de données du premier écho et du second écho qui a la plus grande amplitude et à décaler les données d'écho dans l'un au moins des dispositifs (40, 42) de mémoire de données du premier écho et du second écho de manière que les valeurs de données de la plus grande amplitude soient mises aux mêmes coordonnées à la fois dans les dispositifs (40, 42) de mémoire de données du premier écho et du second écho.

14. Appareil selon la revendication 12 ou 13, comprenant en outre un dispositif (60) de normalisation destiné à multiplier l'amplitude de chaque valeur de données de l'un des dispositifs (40, 42) de mémoire de données du premier écho et du second écho par le rapport des valeurs de données de plus grande amplitude des dispositifs (40, 42) de mémoire de données du premier et du second écho.

15. Appareil selon la revendication 12, 13 ou 14, comprenant en outre un dispositif (74) destiné à multiplier chaque valeur de données du dispositif (40) de mémoire de données du premier écho par la valeur complexe conjuguée de la valeur de données de plus grande amplitude dans le dispositif (40) de mémoire du premier écho et un dispositif (76) de multiplication de chaque valeur de données du dispositif (42) de mémoire de données du second écho par la valeur complexe conjuguée de la valeur de données de plus grande amplitude du dispositif (42) de mémoire de données du second écho.
